# EUROPÄISCHE PATENTSCHRIFT

(11) **EP 0 815 181 B1**
(45) Veröffentlichungstag und Bekanntmachung des Hinweises auf die Patenterteilung: **11.12.2002**
(21) Anmeldenummer: 96908087.8
(22) Anmeldetag: 20.03.1996
(51) Int. Cl.: C09K 11/06, H05B 33/14

(54) **ELEKTROLUMINESZENZVORRICHTUNG MIT EMISSION POLARISIERTEN LICHTES**
ELECTROLUMINESCENCE DEVICE WITH EMISSION OF POLARISED LIGHT
DISPOSITIF ELECTROLUMINESCENT EMETTANT DE LA LUMIERE POLARISEE

(30) Priorität: 20.03.1995 DE 19509450
(43) Veröffentlichungstag der Anmeldung: 07.01.1998
(73) Patentinhaber: Covion Organic Semiconductors GmbH, 65926 Frankfurt (DE)
(72) Erfinder: LUPO, Donald, D-60316 Frankfurt am Main (DE); REMMERS, Marcus, D-55128 Mainz (DE); NEHER, Dieter, D-55128 Mainz (DE)
(74) Vertreter: Luderschmidt, Schüler & Partner GbR
(86) Internationale Anmeldenummer: EP9601202
(87) Internationale Veröffentlichungsnummer: WO96029376

(56) Entgegenhaltungen:
- WO-A-96/03015
- ADVANCED MATERIALS, FEB. 1996, VCH VERLAGSGESELLSCHAFT, GERMANY, Bd. 8, Nr. 2, ISSN 0935-9648, Seiten 146-149, XP002006459 CIMROVA V ET AL: "Polarized light emission from LEDs prepared by the Langmuir-Blodgett technique"
- INTERNATIONAL CONFERENCE ON SCIENCE AND TECHNOLOGY OF SYNTHETIC METALS (ICSM '94), SEOUL, SOUTH KOREA, 24-29 JULY 1994, Bd. 71, Nr. 1-3, ISSN 0379-6779, SYNTHETIC METALS, 1 APRIL 1995, SWITZERLAND, Seiten 2121-2124, XP002006460 INGANAS O ET AL: "Thiophene polymers in light emitting diodes: making multicolour devices"
- ADVANCED MATERIALS, NOV. 1995, VCH VERLAGSGESELLSCHAFT, GERMANY, Bd. 7, Nr. 11, ISSN 0935-9648, Seiten 923-925, XP002006461 LUESSEM G ET AL: "Polarized photoluminescence of liquid crystalline polymers with isolated arylenevinylene segments in the main chain"
- DATABASE WPI Section Ch, Week 9114 Derwent Publications Ltd., London, GB; Class A85, AN 91-098846 XP002006462 & JP,A,03 043 991 (CANON KK) , 25.Februar 1991

## Beschreibung

Es besteht ein hoher industrieller Bedarf an großflächigen Festkörper-Lichtquellen für eine Reihe von Anwendungen, überwiegend im Bereich von Anzeigeelementen, der Bildschirmtechnologie und der Beleuchtungstechnik. Die an diese Lichtquellen gestellten Anforderungen können zur Zeit von keiner der bestehenden Technologien völlig befriedigend gelöst werden.

Als Alternative zu herkömmlichen Anzeige- undloder Beleuchtungselementen, wie Glühlampen, Gasentladungslampen und nicht selbstleuchtenden Flüssigkristallanzeigeelementen, sind bereits seit einiger Zeit Elektrolumineszenz(EL)materialien und -vorrichtungen, wie lichtemittierende Dioden (LED), in Gebrauch.

Neben anorganischen Elektrolumineszenzmaterialien und -vorrichtungen sind seit etwa 30 Jahren auch niedermolekulare, organische Elektrolumineszenzmaterialien und -vorrichtungen bekannt (siehe z. B. US-A-3,172,862). Bis vor kurzem waren aber solche Vorrichtungen in ihrer praktischen Anwendbarkeit stark eingeschränkt.

In der WO 90/13148 und der EP-A 0 443 861 werden Elektrolumineszenzvorrichtungen beschrieben, die einen Film aus einem konjugierten Polymer als lichtemittierende Schicht (Halbleiterschicht) enthalten. Solche Vorrichtungen bieten zahlreiche Vorteile, wie die Möglichkeit, großflächige, flexible Displays einfach und kostengünstig herzustellen. Solche Displays sind selbstleuchtend und benötigen daher keine zusätzliche rückwärtige Beleuchtungsquelle. Unstrukturierte Elektrolumineszenz-Vorrichtungen können ferner als Hintergrundbeleuchtungsquelle in Flüssigkristallanzeigen eingesetzt werden. Im Gegensatz zu herkömmlichen Vorrichtungen mit Leuchtrohr und Lichtstreuungsgitter bieten solche Vorrichtungen Vorteile hinsichtlich Dicke und Gewicht. Aufgrund der statistischen Verteilung der Polymerhauptketten ist das emittierte Licht aus Elektrolumineszenzvorrichtungen jedoch nicht polarisiert.

Insbesondere im Bereich von Anzeigeelementen ist jedoch eine Emission polarisierten Lichtes von besonderer Bedeutung. Die Hintergrundbeleuchtung herkömmlicher LCD-Displays, z. B. in Computerbildschirmen, muß polarisiert sein. Ist das emittierte Licht selbst polarisiert, so kann auf eine Polarisatorfolie mit den entsprechenden Intensitätsverlusten verzichtet werden.

Eine typische Elektrolumineszenz-Vorrichtung gemäß der WO 90/13148 besteht aus einer lichtemittierenden Schicht in Form eines dünnen, dichten Polymerfilms (Halbleiterschicht), der mindestens ein konjugiertes Polymer enthält. Eine erste Kontaktschicht steht in Kontakt mit einer ersten Oberfläche, eine zweite Kontaktschicht mit einer weiteren Oberfläche der Halbleiterschicht. Der Polymerfilm der Halbleiterschicht hat eine genügend geringe Konzentration von extrinsischen Ladungsträgern, so daß beim Anlegen eines elektrischen Feldes zwischen den beiden Kontaktschichten Ladungsträger in die Halbleiterschicht eingebracht werden, wobei die eine Kontaktschicht positiv gegenüber der anderen wird und die Halbleiterschicht Strahlung aussendet.

Die in solchen Vorrichtungen verwendeten Polymere sind im allgemeinen konjugiert. Unter konjugiertem Polymer versteht man ein Polymer, das ein delokalisiertes Elektronensystem entlang der Hauptkette besitzt. Das delokalisierte Elektronensystem verleiht dem Polymer Halbleitereigenschaften und gibt ihm die Möglichkeit, positive und/oder negative Ladungsträger mit hoher Mobilität zu transportieren.

Polarisierte Elektrolumineszenz an Polymerfilmen wurde an verstrecktem Polythiophen beobachtet (P. Dyreklev, M. Berggren, O. Inganäs, M. R. Andersson, O. Wennerström, T. Hjertberg, Adv. Mat. **1995,** 7, 43). Das Verhältnis von parallel zu senkrecht polarisiertem Licht betrug dabei 2,4. Bei dieser Methode ist jedoch eine genaue Filmdicke und Homogenität nicht einstellbar und durch den Prozeß des mechanischen Verstreckens können Risse im Polymerfilm auftreten.

Beim Aufbau der lichtemittierenden Schichten mit Hilfe herkömmlicher Techniken, wie spin-coating (siehe z. B. H. Frey, G. Kienel, Dünnschichttechnologie, VDI Verlag, Düsseldorf, 1987), kommt es zu einer nahezu isotropen Orientierung der konjugierten Polymere bezogen auf die Substratfläche. Die abgegebene Strahlung kann daher auch keine Vorzugspolarisation aufweisen.

Bisher konnten mit Hilfe der Langmuir-Blodgett (LB)-Technik nur amphiphile Materialien übertragen werden, die keine Kettensteifigkeit aufweisen und daher auch im fertigen Film keine ausgezeichnete Orientierung aufweisen (siehe z. B. G. Roberts, "Langmuir-Blodgett Films", Plenum, New York, 1990). So wurden bereits Polyimide und Poly-(phenylen-vinylen)-Precursor-Polymere in Elektrolumineszenzvorrichtungen verwendet (EP-A-0 237 017).

In G. Wegner, Thin Solid Films **1992,** 216, 105, sind kettensteife Polymere mit löslichkeitsvermittelnden Alkylseitenketten, wie Polyglutamate, Cellulose, Phthalocyanine oder Poly-(p-phenylene), als neue Klasse von Substanzen beschrieben, die Langmuir-Blodgett Filme ausbilden. In derartigen Polymerfilmen sind die Polymermoleküle parallel zum Substrat ausgerichtet und zeigen anisotropes Verhalten in bezug auf verschiedene physikalische Eigenschaften. Die Oberflächen solcher LB-Filme sind sehr homogen und die Dicke der Schichten läßt sich sehr genau einstellen.

Die Anisotropien der Photolumineszenz, die bei konjugierten, kettensteifen Polymeren (Poly-(p-phenylen)) in Langmuir-Blodgett Filmen bisher maximal erreicht werden konnten liegen im Bereich von 2,6 (T. Vahlenkamp, G. Wegner, Makromol. Chem. Phys. **1994,** 195, 1933; T. Vahlenkamp, Dissertation, Mainz 1992).

Aufgabe der vorliegenden Erfindung war es, eine Elektrolumineszenzvorrichtung bereitzustellen, die bei Verwendung in Beleuchtungs- und/oder Anzeigevorrichtungen geeignet ist, das Eigenschaftsprofil bisher verwirklichter Vorrichtungen zu verbessern.

Es wurde nun überraschend gefunden, daß durch schichtweisen Aufbau geeigneter, hochgeordneter Polymerschichten Elektrolumineszenzvorrichtungen hergestellt werden können, die die Emission parallel polarisierter Strahlung ermöglichen, wobei der Polarisationsgrad des Lichtes aus diesen Vorrichtungen die bisher bekannten Werte erheblich übersteigt. Das von den Emittermolekülen abgestrahlte Licht weist dabei erhebliche Amisotropien der Polarisationsrichtung parallel und senkrecht zur Schichtlängsachse auf.

Gegenstand der Erfindung ist daher eine Elektrolumineszenzvorrichtung gemäß Anspruch 1.

Vorzugsweise handelt es sich um ein konjugiertes oder teilkonjugiertes Polymer, besonders bevorzugt ein konjugiertes, kettensteifes und in organischen Lösungsmitteln lösliches Polymer.

Vorzugsweise ist die Intensität des Lichtes, das parallel zur Längsachse des Substrates polarisiert ist, mindestens dreimal, vorzugsweise mindestens viermal, so groß, wie die senkrecht dazu polarisierte Intensität.

Das Polarisationsverhältnis wird mit Hilfe eines drehbar angebrachten Analysators (Polarisationsfilter) gemessen, indem die Intensität des emittierten Lichtes als Funktion des Drehwinkels des Analysators bestimmt wird. Das Polarisatonsverhältnis ist definitionsgemäß das Verhältnis zwischen maximaler und minimaler gemessener Intensität.

Zur Herstellung der erfindungsgemäßen Elektrolumineszenzvorrichtung wird die lichtemittierende Schicht vorzugsweise Monoschicht für Monoschicht mit Hilfe von Flüssig-Gas-Grenzflächen Übertragungsmethoden (z. B. mit der Langmuir-Blodgett-Technik) aufgebaut (siehe z. B. A. Ulman, An Introduction to Ultrathin Organic Films, Acad. Press, Boston, 1991). Diese Schichtsysteme weisen bei Verwendung geeigneter Substanzen eine hohe molekulare Ordnung auf.

Geeignete Polymere für derartige Anwendungen sind lösliche, konjugierte, kettensteife Polymere gemäß Anspruch 1, die aus Arylen- oder Heteroaryleneinheiten auch in Kombination mit ungesättigten Einheiten (z. B. PPP, PPV, PT) aufgebaut werden. Die Verarbeitbarkeit derartiger Substanzen aus Lösung kann durch den Einbau von flexiblen Seitenketten an das Polymer erreicht werden. Unter kettensteifen Polymeren werden solche verstanden, bei denen das Rückgrat strukturbedingt eine vorwiegend lineare Konfiguration einnehmen muß.

In organischen Lösungsmitteln löslich bedeutet im Sinne der Erfindung, daß sich das Polymer in mindestens einem wasserunmischbaren organischen Lösungsmittel oder einem Gemisch aus solchen in einer Konzentration von mindestens 0,3 mg/ml bei 20 °C lösen läßt.

Überraschenderweise läßt sich die erfindungsgemäße Elektrolumineszenzvorrischtung durch direkten Aufbau der lichtemittierenden Schicht herstellen, ohne daß eine nachhergehende Modifikation, wie Verstrecken, notwendig wäre.

Gegenstand der Erfindung ist daher auch eine Elektrolumineszenzvorrichtung gemäß Anspruch 2.

Die in Anspruch 1 eingesetzten Polymere enthalten ein, das mindestens ein Strukturelement der allgemeinen Formel (AₖBₗ)ₙ enthält, wobei die Symbole und Indizes folgende Bedeutungen haben:
- A: ist gleich oder verschieden 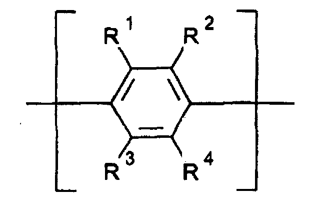
- B: ist gleich oder verschieden 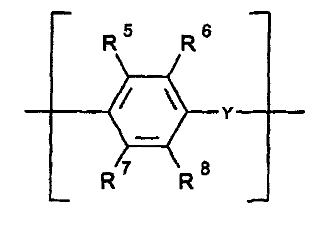
- Y: ist gleich oder verschieden (E)-CR⁹=CR¹⁰-
- R¹, R², R³, R⁴, R⁵, R⁶, R⁷, R⁸, R⁹, R¹⁰: sind in den einzelnen Strukturelementen unabhängig voneinander gleich oder verschieden H, eine geradkettige oder verzweigte Alkylkette mit 1 bis 22 C-Atomen, wobei eine oder mehrere nicht benachbarte CH₂-Gruppen auch durch -O-, -S-, -SO₂-, -COOC-, -OOC- und/oder Phenylen, vorzugsweise 1,4-Phenylen, ersetzt sein können, Aryl- oder Aryloxygruppen, vorzugsweise mit 4 bis 14 C-Atomen, wobei der Aromat in diesen Gruppen mit C₁-C₂₂-Alkyl, C₁-C₂₂-Alkoxy, Br, Cl, F und/oder CN substituiert sein kann, Br, Cl, F, CN oder Alkyloxycarbonyl mit 2 bis 23 C-Atomen;
- k: ist 0 bis 25;
- l: ist 0 bis 25, wobei die Summe k + l ≥ 1 ist;
- n: ist 1 bis 200;
wobei die Summe aller n im Bereich von 3 bis 200 liegt.

Ein bevorzugtes lösliches, konjugiertes, kettensteifes Polymer ist ein Oligo-pphenyleneinheiten enthaltendes Polymer definiert in Anspruch 1.

Bevorzugt sind Polymere bei denen I gleich 0 ist.

Ebenso bevorzugt sind Polymere, bei denen ein oder zwei, vorzugsweise zwei, besonders bevorzugt in 2,5-Position stehende, Reste R¹, R², R³, R⁴ bzw. R⁵, R⁶, R⁷, R⁸ jeweils eine Alkylgruppe mit 2 bis 22 C-Atomen bedeuten, wobei vorzugsweise eine oder mehrere, besonders bevorzugt eine, CH₂-Gruppe durch ein Heteroatom, das gegebenenfalls mit einem weiteren aliphatischen oder aromatischen Kohlenwasserstoffrest mit vorzugsweise 1 bis 22 C-Atomen substituiert ist, ersetzt sind und eine weitere CH₂-Gruppe durch eine, gegebenenfalls substituierte, Phenylengruppe ersetzt sein kann und wobei die übrigen Reste R¹ bis R⁸ H bedeuten.

Bevorzugte Heteroatome sind -O-, -S-.

Ganz besonders bevorzugt sind R¹, R⁴, R⁵ und R⁸ gleich oder verschieden eine geradkettige oder verzweigte Alkoxygruppe mit 1 bis 22 C-Atomen.

Insbesondere bevorzugt sind Polymere beschrieben durch die Formeln (A) und (B), bei denen R², R³, R⁶, R⁷, R⁹ und R¹⁰ Wasserstoff bedeuten und bei denen R¹ gleich R⁴ und R⁵ gleich R⁸ sind und eine geradkettige oder verzweigte Alkoxygruppe mit 4 bis 7 C-Atomen bedeuten.

Bevorzugt sind die Indizes k, l eine natürliche Zahl im Bereich von 1 bis 13, besonders bevorzugt 1, 2 oder 3, ganz besonders bevorzugt 2 oder 3.

Vorzugsweise besteht ein erfindungsgemäß verwendetes Polymer aus Strukturelementen der allgemeinen Formel (AₖBₗ)ₙ.

Dabei ist es bevorzugt, daß die Polymerkette nur ein Strukturelement der allgemeinen Formel (AₖBₗ) mit einem bestimmten k und I enthält. Der Index n liegt dann vorzugsweise im Bereich von 5 bis 75.

Ebenso bevorzugt können die erfindungsgemäßen Polymere mehrere unterschiedliche Strukturelemente der Formel (AₖBₗ) aufweisen. Hierbei ist anzumerken, daß das Strukturelement A nicht nur über die Reste R¹ bis R⁴ variiert werden kann, sondern auch über die Indizes k und l.

Bevorzugt sind in solchen Fällen statistische Copolymere, wie sie durch die Formel [(A¹ₖB¹ₗ)_{o,x}(A²ₖB²ₗ)_{o,y} .... (AⁿₖBⁿₗ)_{o,n}]ₘ mit 0,x + 0,y .... + 0,n = 1 und 3 ≤ m ≤ 200, wiedergegeben werden. Solche statistischen Copolymere enthalten vorzugsweise 2 bis 8 verschiedene Strukturelemente der Formel (AₖBₗ).

Ebenso bevorzugt sind Blockcopolymere der Formel [(A¹ₖB¹ₗ)ₓ(A²ₖB²ₗ)_{y} - .... (AⁿₖBⁿₗ)ₙ]ₘ, wobei 3 ≤ m ≤ 200 gilt. Bevorzugt sind dabei Blockcopolymere, die zwei verschiedene Strukturelemente der Formel (AₖBₗ) enthalten. x und y liegen vorzugsweise im Bereich von 1 bis 199, besonders bevorzugt von 2 bis 50, wobei x+y ≤ 200 ist.

Beim Vorhandensein von mehreren verschiedenen Strukturelementen der allgemeinen Formel (AₖBₗ)ₙ kann jedes einzelne Element Werte für n im Bereich von 1 bis 200 annehmen, vorausgesetzt, daß die Summe aller n im Bereich von 3 bis 200, vorzugsweise im Bereich von 5 bis 75, liegt.

Die Herstellung der erfindungsgemäß verwendeten Polymere ist nach verschiedenen Methoden möglich. Sie kann nach an sich literaturbekannten Methoden, wie sie in Standardwerken zur Organischen Synthese, z. B. Houben-Weyl, Methoden der Organischen Chemie, Georg-Thieme-Verlag, Stuttgart, beschrieben werden, erfolgen. Die Herstellung erfolgt dabei unter Reaktionsbedingungen, die für die genannten Umsetzungen bekannt und geeignet sind. Dabei kann auch von an sich bekannten, hier nicht näher erwähnten Varianten Gebrauch gemacht werden.

Beispielsweise können Derivate des Benzols und des Stilbens oxidativ (z. B. mit FeCl₃, siehe u.a. P. Kovacic, N.B. Jones, Chem. Ber. **1987**, 87, 357; M.Wede, T. Abe, H. Awano, Macromolecules **1992**, 25, 5125) oder elektrochemisch (siehe z.B. N. Saito, T. Yamamoto, Polym. Bull. **1993,** 30, 285) polymerisiert werden.

Ebenso können die Polymere aus Dihalogenaromaten unter Kupfer/Triphenylphosphin - (siehe z. B. G.W. Ebert, R.D. Rieke, J. Org. Chem. **1988**, 53, 4482) oder Nickel/Triphenylphosphin-Katalyse (siehe z. B. H. Matsumoto, S. Inaba, R.D. Rieke, J. Org. Chem. **1993,** 48, 849) synthetisiert werden.

Aromatische Distannane lassen sich, wie z. B. bei J.K. Stille, Angew. Chem., Int. Ed. Engl. **1986**, 25, 508 angegeben, unter Palladiumkatalyse polymerisieren.

Weiterhin können aromatische Dibromverbindungen in die Dilithio- oder Digrignardverbindungen überführt werden, die dann mit einer weiteren Dibromverbindung mittels CuCl₂ (siehe z. B. G. Wittig, G. Klar, Liebigs Ann. Chem. **1967**, 704, 91; H.A. Staab, F. Bunny, Chem. Ber. **1967**, 100, 293; T. Kaufmann, Angew. Chem. **1974,** 86, 321) oder durch Elektronentransfer ungesättigter 1,4-Dihalogenverbindungen (siehe z. B. S.K. Taylor, S.G. Bennet, K.J. Harz, L.K. Lashley, J. Org. Chem. **1981,** 46, 2190) polymerisiert werden.

Darüber hinaus lassen sich die Polymere durch Umsetzung der erwähnten Dibromverbindungen mit Nickelkatalysatoren in Gegenwart von 2,2'-Bipyridinen polymerisieren (siehe K. Chmil, U. Scherf, Makromol. Chem., Rapid Commun. **1993,** 14, 217).

Bevorzugt ist jedoch ein Verfahren, das dadurch gekennzeichnet ist, daß man eine oder mehrere Verbindungen der Formel (I) 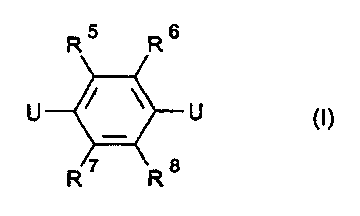 mit einer oder mehreren Verbindungen der Formel (II) und/oder (III) 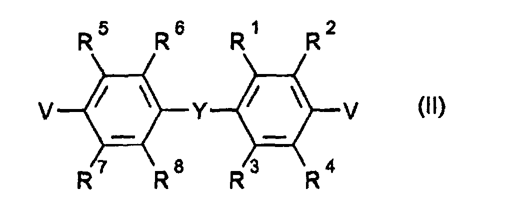 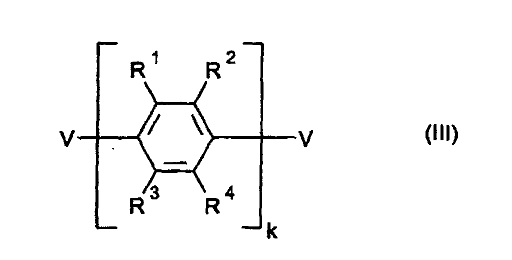 in einem inerten organischen Lösungsmittel oder Lösungsmittelgemisch mit mindestens einer Verbindung, die Palladium enthält, und gegebenenfalls einer Zusatzsubstanz umsetzt, wobei die Symbole und Indizes in den Formeln (I) bis (III) folgende Bedeutungen haben:
- U und V: sind verschieden voneinander ein Halogen aus der Gruppe I, Br und Cl, vorzugsweise Br, oder BQ₁Q₂;
- Q₁, Q₂: sind gleich oder verschieden -OH, C₁-C₁₀-Alkoxy, C₁-C₁₀-Alkyl, Phenyl, das gegebenenfalls durch C₁-C₁₀-Alkyl, C₁-C₁₀-Alkoxy oder Halogen substituiert sein kann, oder Halogen oder Q₁ und Q₂ zusammen bilden eine C₁-C₄-Alkylendioxy-Gruppe, eine Methylengruppe, die gegebenenfalls durch eine oder zwei C₁-C₄-Alkylgruppen substituiert sein kann, oder Q₁ und Q₂ und das Boratom zusammen sind Teil einer Boroxinrings der Formel (IV) 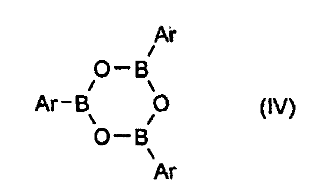
- Ar: ist ein aromatischer Rest der Formel (I), (II) oder (III);
- Y: ist gleich oder verschieden (E)-CR⁹=CR¹⁰-;
- R¹, R², R³, R⁴, R⁵, R⁶, R⁷, R⁸, R⁹, R¹⁰: sind in den einzelnen Strukturelementen unabhängig voneinander gleich oder verschieden, H, eine geradkettige oder verzweigte Alkylkette mit 1 bis 22 C-Atomen, wobei eine oder mehrere nicht benachbarte CH₂-Gruppen auch durch -O-, -S-, -SO₂-, -COOC-, -OOC- und/oder Phenylen, vorzugsweise 1,4-Phenylen, ersetzt sein können, Aryl- oder Aryloxygruppen, vorzugsweise mit 4 bis 14 C-Atomen, wobei der Aromat in diesen Gruppen mit C₁-C₂₂-Alkyl, C₁-C₂₂-Alkoxy, Br, Cl, F, CN, und/oder NO₂ substituiert sein kann, Br, Cl, F, CN, NO₂ oder Alkyloxycarbonyl mit 2 bis 23 C-Atomen;
- k: ist 1 bis 25, bevorzugt 1 bis 13, besonders bevorzugt 1, 2 oder 3, insbesondere 2 oder 3.

Vorteilhafterweise werden annähernd äquimolare Mengen des Boronsäure(esters) und der Halogenverbindung umgesetzt. Bevorzugt ist es, den Boronsäure(ester) in einem 1,001 bis 1,1, besonders bevorzugt 1,025-fachen Überschuß einzusetzen.

Die Umsetzung erfolgt im allgemeinen bei einer Temperatur im Bereich von 0 bis 150°C, vorzugsweise bei 20 bis 100°C und besonders bevorzugt bei 70 bis 90°C. Die Reaktionsdauer liegt im allgemeinen bei einer Stunde bis üblicherweise 3 bis 5 Tagen.

Bevorzugte Lösungsmittel sind Gemische, deren Komponenten unter den Reaktionsbedingungen mischbar oder nicht mischbar, vorzugsweise nicht mischbar, sind. Bevorzugt für die erste Komponente ist ein polar protisches Lösungsmittel, wie Wasser. Bevorzugt als weitere Komponente sind N,N-Dialkylamide, wie Dimethylformamid (DMF), N-Methyl-2-pyrrolidon, Ether, wie Tetrahydrofuran (THF), aromatische Kohlenwasserstoffe, wie Toluol, und Gemische der angeführten Lösungsmittel. Besonders bevorzugt ist eine binäre Mischung aus THF und Wasser, insbesondere im Verhältnis 1 : 1.

Verbindungen, die Palladium enthalten, zeigen katalytische Aktivität für die Polymerisationsreaktion. Bevorzugt sind Verbindungen, die Palladium in der Oxidationsstufe 0 enthalten oder unter den Reaktionsbedingungen Palladium(O)-Spezies bilden, besonders bevorzugt ist Tetrakis-(triphenylphosphin)-palladium (0), das direkt eingesetzt werden kann. Im allgemeinen wird eine Konzentration von 1 mol% Katalysator pro Mol der eingesetzten Monomermenge verwendet.
Als Zusatzsubstanz werden im allgemeinen schwache Basen verwendet, bevorzugt ist Natriumhydrogencarbonat in einer Konzentration von 1 mol/l, bezogen auf die eingesetzte Menge Wasser.

Zur Herstellung von statistischen Copolymeren können beispielsweise unterschiedliche Verbindungen der Formel (I) und (II) oder (I) und (III) oder (I) und (II) und (III) gemeinsam polymerisiert werden.

Auch verschiedene Bromderivate (U bzw. V ist Br) können, z. B. wie oben angegeben unter Ni°-Katalyse, zu statistischen Copolymeren gekuppelt werden.

Zur Herstellung von Blockcopolymeren wird beispielsweise eine Halogenkomponente mit einem so großen Überschuß einer Boronsäure(ester)komponente umgesetzt, daß Oligomere einer definierten Länge mit endständigen Boronsäure(ester)-Gruppen entstehen. Ein zweiter Block wird durch Umsetzung einer Boronsäure(ester)-Komponente mit einem entsprechenden Überschuß einer Halogenkomponente erzeugt; die Oligomeren dieses zweiten Blocks haben endständige Halogenfunktionen. Alternativ können derartige terminierte Oligomere auch durch Borierung von Brom-termierten Oligomeren aufgebaut werden. Umsetzung der beiden Blöcke im Verhältnis 1:1 führt zu erfindungsgemäßen Blockcopolymeren.

Eine weitere Möglichkeit der Unterbrechung der Konjugation entlang der Polymer Hauptkette besteht im definierten Einsatz von Monomeren, die eine 1,3-Dibrom-Substitution aufweisen. Im resultierenden Polymer tritt ein entsprechender Knick auf, der die Konjugation effektiv unterbindet.

Dieses Monomer wird an Stelle des entsprechenden Stilbendibromid-Monomers so eingesetzt, daß das ungefähr äquimolare Verhältnis von Dibromid zu Diboronsäure nicht verändert wird.

Die Aufarbeitung erfolgt nach den bekannten, dem Fachmann geläufigen Methoden. Beispielsweise kann man die Reaktionsmischung in Methanol gießen, filtrieren, mit Wasser waschen, extrahieren und das erhaltene Rohprodukt durch Umfällen weiter reinigen.

Die Herstellung der Monomerbausteine der Formeln (I) bis (III) kann nach an sich literaturbekannten Methoden, wie sie in Standardwerken zur Organischen Synthese, z. B. Houben-Weyl, Methoden der Organischen Chemie, Georg-Thieme-Verlag, Stuttgart, beschrieben werden, erfolgen. Die Herstellung erfolgt unter Reaktionsbedingungen, die für die genannten Umsetzungen bekannt und geeignet sind. Dabei kann auch von an sich bekannten, hier nicht näher erwähnten Varianten Gebrauch gemacht werden.

Methoden zur Synthese substituierter 1,4-Dibrombenzole oder weiterer 1,4-Dihalogenverbindungen sind als Standardreaktionen bekannt (siehe z. B. J. March, Advanced Organic Chemistry, 4. Aufl., S. 531 - 534, John Wiley & Sons, New York 1992).

1,4-Dibrom-alkyl-benzole sind beispielsweise durch Alkylierung von 1,4-Dihalogenbenzolen durch Grignard-Reaktion und anschließende regioselektive Bromierung in 2,5-Stellung herstellbar.

1,4-Dibrom(pseudo)halogenverbindungen sind beispielsweise aus den entsprechenden Dibromiden durch Austausch mit beispielsweise Cyanogruppen zugänglich (M. Rehahn, A.-D. Schlüter, W.J. Feast, Synthesis **386**, 1988).

Entsprechend sind auch zahlreiche Wege zur Synthese der Oligo-p-phenylen- und Stilben-Derivate anwendbar.

Oligo-p-phenylene lassen sich beispielsweise nach den oben erwähnten Methoden aus den entsprechenden Monomeren aufbauen.

Stilbenderivate lassen sich beispielsweise nach den in Houben-Weyl, Methoden der Organischen Chemie, Georg-Thieme-Verlag, Stuttgart, beschriebenen Methoden synthetisieren (z. B. Wittig Reaktion, Knoevenagel Reaktion, Heck-Reaktion).

Die obengenannten Polymere lassen sich auch als Mischungen einsetzen. Überraschenderweise sind Polymere mit I = O in der Lage auch mit solchen Additiven LB Filme auszubilden, die alleine keine oder nur sehr schlecht LB-Filme bilden.

Bevorzugt werden Polymere mit I = O in Mischung mit Polymeren eingesetzt, in denen Y -CR⁹=CR¹⁰- bedeutet.

Die Mischungen können bis zu 50 % der Gesamtmenge an Additiv enthalten, vorzugsweise beträgt die Menge an Additiv nicht mehr als 30 % der Gesamtmenge. Als Additive sind neben Polymeren auch niedermolekulare, anisotrope Farbstoffmoleküle möglich.
Das Einbringen der Additive kann durch Cospreiten erfolgen, ebenso durch nachträgliches Einstellen des Additivs, vorzugsweise eines Farbstoffs, in den fertigen Film.

Der allgemeine Aufbau von Elektrolumineszenzvorrichtungen ist beispielsweise in der US-A-4,539,507 und der US-A-5,151,629 beschrieben. Polymere enthaltende Elektrolumineszenzvorrichtungen sind beispielsweise in der WO 90/13148 und der EP-A O 443861 beschrieben.

Die Herstellung der erfindungsgemäßen Elektrolumineszenzvorrichtung erfolgt nach bekannten, dem Fachmann geläufigen Methoden.

In einer bevorzugten Ausführungsform wird das Elektrolumineszenzmaterial, vorzugsweise ein oder mehrere der oben beschriebenen Polymere, mit Hilfe von Flüssig-Gas-Grenzflächen Übertragungsmethoden Monoschicht für Monoschicht aufgebaut. Solche Methoden sind beispielsweise bei A.Ulman, An Introduction to Ultrathin Organic-Films, Acad. Press, Boston, **1991**, beschrieben.

Besonders bevorzugt erfolgt das Auftragen nach der Langmuir-Blodgett-Technik, die bei A.Ulman, loc. cit., chapter 2, ausführlich dargestellt ist. Eine weitere Beschreibung dieser Methode sowie Literatur zum Thema findet sich in Ullmann=s Encyclopaedia of Technical Chemistry, 5th ed., Verlag Chemie, Weinheim **1985** unter dem Stichwort Thin Films.

Bei der üblichen Methode zur Herstellung von LB-Schichten werden amphiphile Moleküle, die nicht wasserlöslich sind, in Form einer verdünnten Lösung (typischerweise < 1 g/l) in einem leichtflüchtigen Lösungsmittel (z. B. Methylenchlorid) auf einer Wasseroberfläche in einer Beschichtungsapparatur, z. B. einem sogenannten Langmuir-Trog gespreitet. Nach Verdampfen des Lösungsmittels werden die Moleküle durch Verringerung der ihnen zur Verfügung stehenden Wasseroberfläche zu einem dichten Film komprimiert, bis ein zur Übertragung des Films geeigneter Kompressionszustand erreicht ist. Die Verringerung der Oberfläche erfolgt durch Bewegung einer festen Barriere oder auch durch Verschieben eines geschlossenen flexiblen Bandes, das die amiphiphilen Moleküle an der Wasseroberfläche einschließt. Die Kompression kann aber auch über rotierende Walzen (Barraud et al., Thin Solid Films **1983**, 99, 221) oder Strömung des Wassers (US-A-4 722 856, EP-A-0 433 325 oder EP-A-0 583 676) erfolgen. Die Übertragung des Films von der Wasseroberfläche auf einen Träger geschieht durch Ein- oder Austauchen des Trägers durch die filmbedeckte Wasseroberfläche. Insbesondere ist die Übertragung von Mehrfachschichten durch Wiederholung der Tauchvorgänge möglich, wobei pro Tauchgang eine monomolekulare Schicht übertragen wird.

Die erfindungsgemäße Elektrolumineszenzvorrichtung enthält üblicherweise eine elektrolumineszierende Schicht zwischen einer Kathode und einer Anode, wobei mindestens eine der Elektroden transparent ist. Zusätzlich kann zwischen der elektrolumineszierenden Schicht und der Kathode eine Elektroneninjektionsund/oder Elektronentransportschicht eingebracht sein und/oder zwischen der elektrolumineszierenden Schicht und der Anode eine Lochinjektions- undloder Lochtransportschicht eingebracht sein. Als Kathode können z. B. Ca, Mg, Al, Mg/Al dienen. Als Anode können z. B. Au oder ITO (Indiumoxid/Zinnoxid) auf einem transparenten Substrat, z. B. aus Glas oder einem transparenten Polymer, dienen. Im Betrieb wird die Kathode auf negatives Potential gegenüber der Anode gesetzt. Dabei werden Elektronen von der Kathode in die Elektroneninjektionsschicht/Elektronentransportschicht bzw. direkt in die lichtemittierende Schicht injiziert. Gleichzeitig werden Löcher von der Anode in die Lochinjektionsschicht/Lochtransportschicht bzw. direkt in die lichtemittierende Schicht injiziert.

Die injizierten Ladungsträger bewegen sich unter dem Einfluß der angelegten Spannung durch die aktiven Schichten aufeinander zu. Dies führt an der Grenzfläche zwischen Ladungstransportschicht und lichtemittierender Schicht bzw. innerhalb der lichtemittierenden Schicht zu Elektronen/Loch-Paaren, die unter Aussendung von Licht rekombinieren. Die Farbe des emittierten Lichtes kann durch die als lichtemittierende Schicht verwendete Verbindung variiert werden.

Elektrolumineszenzvorrichtungen finden Anwendung z. B. als selbstleuchtende Anzeigeelemente, wie Kontrollampen, alphanumerische Displays, Hinweisschilder, und in optoelektronischen Kopplern.

Bevorzugt ist die Verwendung als Hintergrundbeleuchtung für Flüssigkristallanzeigen.

Der Inhalt der in Beschreibung und Beispielen zitierten Schriften gilt durch Zitat als Bestandteil der Beschreibung.

Die Erfindung wird durch die Beispiele näher erläutert, ohne dadurch beschränkt zu werden.

### Beispiel 1

Ein Quarzglasträger wird zunächst mit Aceton abgerieben, 15 Minuten in Methylenchlorid im Ultraschallbad vorgereinigt. 30 Minuten in einer Reaktionslösung bestehend aus 10 % Wasserstoffperoxid (30 %ig), 40 % wäßrig. konz. Ammoniaklösung und 50 % Milli-Q-Wasser (entionisiertes Wasser mit einer Leitfähigkeit von 0,5 µS/cm) behandelt und anschließend 10 Minuten in einem Strom von Milli-Q-Wasser gewaschen. Bei 2 x 10⁻⁵ mbar werden 2 mm breite Streifen von zunächst Chrom (4 nm) und anschließend Gold (17 nm) aufgedampft. Der auf diese Weise vorbereitete Glasträger wird 5 Minuten bei 1 mbar im Argon-Plasma behandelt und anschließend 30 Minuten in einer 30 %igen Lösung von Hexamethyldisilazan in Chloroform hydrophobiert.

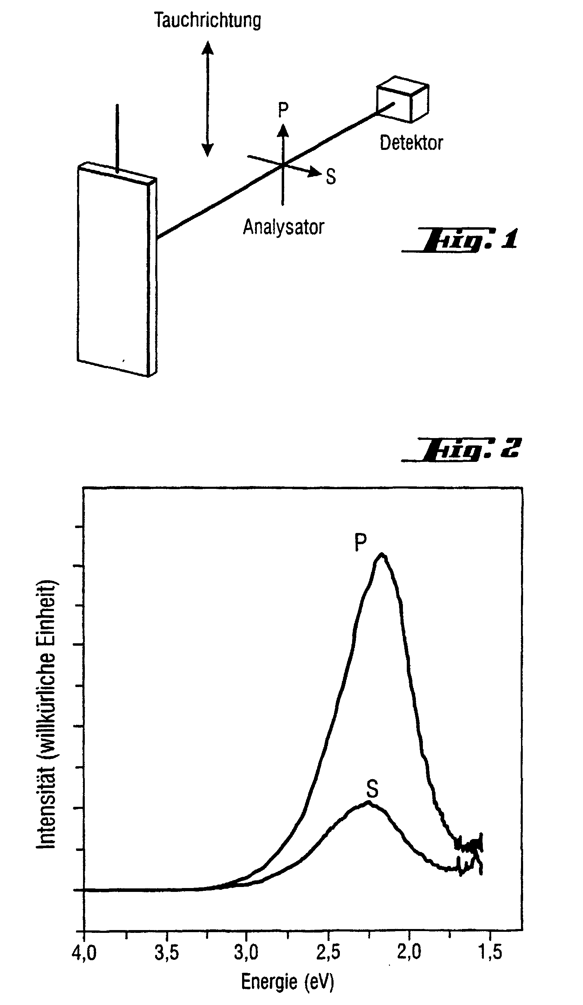

Die Filmübertragung geschieht mit Hilfe einer Lauda Filmwaage FW-1, die auf einer Granitplatte in einer "Laminar-Flow-Box" untergebracht ist. Die Beschichtung erfolgt bei automatischer Filmdruck-Konstanthaltung. Als Subphase dient Milli-Q-Wasser, die Temperierung der Subphase erfolgt über einen an die Filmwaage angeschlossenen Thermostaten. Zum Aufbringen der Polymerschicht als Langmuir-Blodgett-Film wird 1 mg Poly-(p-2,5-di-isopentyl-oxy-phenylen) (M_{w} = 10000) in 3 ml Chloroform gelöst. Das Polymer wird hergestellt wie bei M. Rehan, A.D. Schlüter, G. Wegener, J. Peast, Polymer **1989,** 30, 1060; Th. Valenkamp, G. Wegener, Macromol. Chem. Phys. **1994,** 195, 1933 und V. Cimova, M. Remmers, D. Neher, G. Wesner, Adv. Matter **1995** (im Druck), beschrieben. Bei einer Subphasentemperatur von 6°C werden 30 Tropfen der Polymerlösung vorsichtig auf die Wasseroberfläche gegeben. Der Polymerfilm wird bis zu einem Druck von 8 mN/m komprimiert. Nach 30 Minuten Wartezeit wird der vorbereitete Glasträger mit einer Geschwindigkeit von 1 cm/min 2cm tief in den LB-Trog getaucht und nach 10 Sekunden Wartezeit wieder herausgehoben. Die Wartezeit bis zum Beginn eines neuen Zyklus beträgt 5 Minuten. Auf diese Weise werden in 50 Zyklen 100 Monolagen der Polymers aufgezogen. Die Übertragungsrate des Polymers von der Wasseroberfläche auf den Glasträger wird mit Hilfe der Bewegung der Barriere detektiert.
Anschließend wird bei 2 x 10⁻⁵ mbar quer zur Goldbeschichtung Al in 2 mm breiten Streifen aufgedampft. Die so erhaltene Vorrichtung Au/Polymer/Al wird in einen Probenhalter gegeben und die Elektroden mit einer Stromquelle verbunden, wobei die Au-Streifen positiv und die Al-Streifen negativ gepolt werden. Beim Anlegen einer Feldstärke von 15 x 10⁷ V/m wird an dem entsprechenden Matrixelement eine intensive, homogene, polarisierte weiße Elektrolumineszenz beobachtet, wobei die Intensität des Lichtes, das parallel zur Längsachse des Substrates polarisiert ist, viermal so groß ist, wie die senkrecht dazu polarisierte Intensität (vgl. Fig. 1 und 2).

### Beispiel 2

Als Substrat wird ein mit Indium Zinn Oxid (ITO) beschichteter Glasträger verwendet, auf dem die Breite der ITO-Streifen 2 mm beträgt. Dieser Glasträger wird mit Isopropanol gereinigt und anschließend 30 Minuten in einer 30 %igen Lösung von Hexamethyldisilazan in Chloroform hydrophobiert.

Die Filmübertragung geschieht mit Hilfe einer Lauda Filmwaage FW-1, die auf einer Granitplatte in einer Laminar-Flow-Box untergebracht ist. Die Beschichtung erfolgt bei automatischer Filmdruck-Konstanthaltung. Als Subphase dient Milli-Q-Wasser, die Temperierung der Subphase erfolgt über einen an die Filmwaage angeschlossenen Thermostaten. Zum Aufbringen der Polymerschicht als Langmuir-Blodgett-Film wird 1 mg Poly-(p-2,5-di-isopentyl-oxy-phenylen) (Mw = 10000) in 3 ml Chloroform gelöst. Bei einer Subphasentemperatur von 6°C werden 30 Tropfen der Polymerlösung vorsichtig auf die Wasseroberfläche gegeben. Der Polymerfilm wird bis zu einem Druck von 8 mN/m komprimiert. Nach 30 Minuten Wartezeit wird der vorbereitete Glasträger mit einer Geschwindigkeit von 1 cm/min 2 cm tief in den LB-Trog getaucht und nach 10 Sekunden Wartezeit wieder herausgehoben. Die Wartezeit bis zum Beginn eines neuen Zyklus beträgt 5 Minuten. Auf diese Weise werden in 50 Zyklen 100 Monolagen der Polymers aufgezogen. Die Übertragungsrate des Polymers von der Wasseroberfläche auf den Glasträger wird mit Hilfe der Bewegung der Barriere detektiert. Anschließend wird bei 2 x 10⁻⁵ mbar quer zur ITO-Beschichtung Al in 2 mm breiten Streifen aufgedampft. Die so erhaltene Vorrichtung ITO/Polymer/Al wird in einen Probenhalter gegeben und die Elektroden mit einer Stromquelle verbunden, wobei die ITO-Streifen positiv und die Al-Streifen negativ gepolt werden. Beim Anlegen einer Feldstärke von 15 x 10⁷ V/m wird an dem entsprechenden Matrixelement eine intensive, homogene, polarisierte weiße Elektrolumineszenz beobachtet, wobei die Intensität des Lichtes, das parallel zur Längsachse des Substrates polarisiert ist, viermal so groß ist, wie die senkrecht dazu polarisierte Intensität.

### Vergleichsbeispiel

Als Substrat wird ein mit Indium Zinn Oxid (ITO) beschichteter Glasträger verwendet, auf dem die Breite der ITO-Streifen 2 mm beträgt. Dieser Glasträger wird in Isopropanol gereinigt. Zum Aufbringen des Polymerfilms werden 20 mg Poly-(p-2,5-di-isopentyloxy-phenylen) (Mw = 10000) in 2 ml Chlorbenzol gelöst. Der Träger wird dadurch beschichtet, daß diese Lösung bei einer Drehzahl von 1000 U.p.M. aufgeschleudert wird. Die resultierende Schichtdicke beträgt ca. 50 nm. Anschließend wird bei 2 x 10⁻⁵ mbar quer zur ITO-Beschichtung Al in 2 mm breiten Streifen aufgedampft. Die so erhaltene Vorrichtung ITO/Polymer/Al wird in einen Probenhalter gegeben und die Elektroden mit einer Stromquelle verbunden, wobei die ITO-Streifen positiv und die Al-Streifen negativ gepolt werden. Beim Anlegen einer Feldstärke von 15 x 10⁷ V/m wird an dem entsprechenden Matrixelement eine intensive, homogene, polarisierte weiße Elektrolumineszenz beobachtet, die keine Polarisierung aufweist.

## Patentansprüche

1. Elektrolumineszenzvorrichtung enthaltend eine lichtemittierende Schicht, die mindestens ein Polymer enthält, **dadurch gekennzeichnet, daß** das Polymer mindestens ein Strukturelement der allgemeinen Formel (AₖBₗ)ₙ enthält, wobei die Symbole und Indizes folgende Bedeutungen haben:
A ist gleich oder verschieden 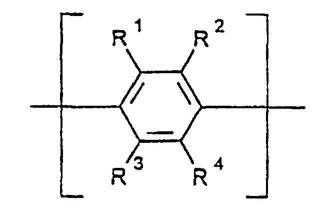
B ist gleich oder verschieden 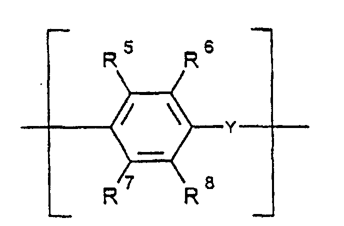
Y ist gleich oder verschieden (E)-CR⁹=CR¹⁰-,
R¹, R², R³, R⁴, R⁵, R⁶, R⁷, R⁸, R⁹, R¹⁰ sind in den einzelnen Strukturelementen unabhängig voneinander gleich oder verschieden H, eine geradkettige oder verzweigte Alkylkette mit 1 bis 22 C-Atomen, wobei eine oder mehrere nicht benachbarte CH₂-Gruppen auch durch -O-, -S-, -SO₂-, -COOC-, -OOC- undloder Phenylen, vorzugsweise 1,4-Phenylen, ersetzt sein können, Aryl- oder Aryloxygruppen, vorzugsweise mit 4 bis 14 C-Atomen, wobei der Aromat in diesen Gruppen mit C₁-C₂₂-Alkyl, C₁-C₂₂-Alkoxy, Br, Cl, F und/oder CN substituiert sein kann, Br, Cl, F, CN oder Alkyloxycarbonyl mit 2 bis 23 C-Atomen;
k ist 0 bis 25;
l ist 0 bis 25, wobei die Summe k + l ≥ 1 ist;
n ist 1 bis 200;
wobei die Summe aller n im Bereich von 3 bis 200 liegt, die emittierte Elektrolumineszenz polarisiert ist, wobei das Polarisationsverhältnis mindestens drei beträgt.

2. Elektrolumineszenzvorrichtung gemäß Anspruch 1, erhältlich durch einen direkten Aufbau der lichtemittierenden Schicht.

3. Elektrolumineszenzvorrichtung gemäß mindestens einem der vorhergehenden Ansprüche, **dadurch gekennzeichnet, daß** die lichtemittierende Schicht mittels Flüssig-Gas-Grenzflächen Übertragungsmethoden aufgebaut ist.

4. Elektrolumineszenzvorrichtung gemäß mindestens einem der vorhergehenden Ansprüche, **dadurch gekennzeichnet, daß** als Flüssig-Gas-Grenzflächen Übertragungsmethode die Langmuir-Blodgett-Technik verwendet wird.

5. Elektrolumineszenzvorrichtung gemäß mindestens einem der Ansprüche 1 bis 4 **dadurch gekennzeichnet, daß** das Polymer ein Blockcopolymer oder ein statistisches Copolymer ist.

6. Verfahren zur Herstellung einer Elektrolumineszenzvorrichtung gemäß mindestens einem der Ansprüche 1 bis 5 **dadurch gekennzeichnet, daß** die lichtemittierende Schicht mittels Flüssig-Gas-Grenzflächen Übertragungsmethoden aufgebaut ist.

7. Verwendung einer Vorrichtung gemäß mindestens einem der Ansprüche 1 bis 5 als Hintergrundbeleuchtung für Flüssigkristallanzeigen.

## Claims

1. Electro-luminescent device containing a light-emitting layer, which contains at least one polymer **characterised in that** the polymer contains at least one structural element of the general formula (AₖBₗ)ₙ, where the symbols and the indices have the following meanings:
A consists of identical or different forms of 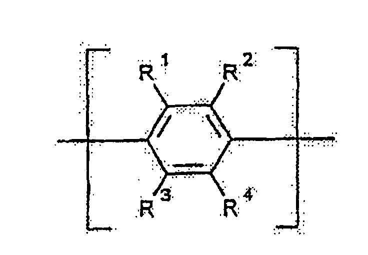
B consists of identical or different forms of 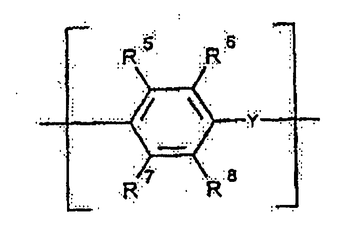
Y consists of identical or different forms of (E)-CR⁹ = CR¹⁰-, in the individual structure elements, R¹, R², R³, R⁴, R⁵, R⁶, R⁷, R⁸, R⁹, R¹⁰, independently of one another, are identical or different selections from H, a straight-chain- or branched alkyl chain with 1 to 22 C-atoms, whereby one or more non-adjacent CH₂-groups may be substituted by -O-, -S-, -SO₂-, -COOC-, -OOC- and / or phenylene, preferably 1,4-phenylene, aryl- or aryloxy groups, preferably with 4 to 14 C-atoms, whereby the aromatic ring in these groups may be substituted with C₁-C₂₂-alkyl, C₁-C₂₂-alkoxy, Br, Cl, F and / or CN; Br, Cl, F, CN or alkyloxycarbonyl with 2 to 23 C-atoms;
k is 0 to 25;
l is 0 to 25, such that the sum of k + l is ≥ 1
n is 1 to 200
where the total sum of all the n values lies within the range 3 to 200, the emitted electro-luminescence is polarised in such a manner that the polarisation ratio amounts to a minimum of three.

2. Electro-luminescent device in accordance with claim 1, obtainable by direct build-up of the light-emitting layer.

3. Electro-luminescent device in accordance with at least one of the foregoing claims, **characterised in that** the light-emitting layer is built up by means of liquid-gas-boundary surface transfer methods.

4. Electro-luminescent device in accordance with at least one of the foregoing claims, **characterised in that** the Langmuir-Blodgett-technique is employed as the liquid-gas boundary surface transfer method.

5. Electro-luminescent device in accordance with at least one of the claims 1 to 4 **characterised in that** the polymer is a block copolymer or a statistical copolymer.

6. Procedure for the manufacture of an electro-luminescent device in accordance with at least one of the claims 1 to 5, **characterised in that** the light emitting layer is built up by means of liquid-gas boundary surface transfer methods.

7. Application of a device in accordance with one of the claims 1 to 5 as background illumination for liquid-crystal displays.

## Revendications

1. Dispositif électroluminescent présentant une couche émettant la lumière, qui renferme au moins un polymère, **caractérisé en ce que** le polymère présente au moins un élément de structure de formule générale (AₖBₗ)ₙ, les symboles et les indices possédant les significations suivantes :
A identiques ou différents représentent 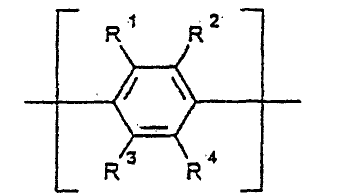
B identiques ou différents représentent 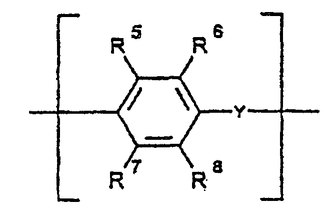
Y identique ou différent représente un groupe (E)-CR⁹=CR¹⁰-,
R¹, R², R³, R⁴, R⁵, R⁶, R⁷, R⁸, R⁹, R¹⁰ représentent dans les différentes éléments de structure, indépendamment les uns des autres, un atome d'hydrogène, une chaîne alkyle linéaire ou ramifiée présentant 1 à 22 atomes de carbone, un ou plusieurs groupes -CH₂- non adjacents pouvant être remplacés par des groupes -O-, -S-, -SO₂-, -COOC-, -OOC- et/ou phénylène, de préférence 1,4-phénylène, des groupes aryle ou aryloxy, de préférence présentant 4 à 14 atomes de carbone, le fragment aromatique dans ces groupes pouvant être substitué par des substituants alkyle en C₁-C₂₂, alkoxy en C₁-C₂₂, Br, Cl, F et/ou CN, Br, Cl, F, CN ou alkoxycarbonyle présentant 2 à 23 atomes de carbone,
k va de 0 à 25 ;
l va de 0 à 25, la somme de k + l ≥ 1 ;
n va de 1 à 200 ;
la somme de tous les n se trouvant dans dans le domaine de 3 à 200,
l'électroluminescence émise étant polarisées, le rapport de polarisation étant d'au moins 3.

2. Dispositif électroluminescent selon la revendication 1, que l'on peut obtenir par une construction directe de la couche émettant la lumière.

3. Dispositif électroluminescent selon au moins l'une des revendications précédentes, **caractérisé en ce que** la couche émettant la lumière est constituée au moyen de la méthode de transfert des couches limites liquide-gaz.

4. Dispositif électroluminescent selon au moins l'une des revendications précédentes, **caractérisé en ce qu'**on utilise en tant que méthode de transfert de couche limite liquide-gaz la technique de Langmuir-Blodgett.

5. Dispositif électroluminescent selon au moins l'une des revendications 1 à 4, **caractérisé en ce que** le polymère est un polymère séquencé ou un polymère statistique.

6. Procédé pour la préparation d'un dispositif électroluminescent selon au moins l'une des revendications 1 à 5, **caractérisé en ce que** la couche émettant la lumière est construite au moyen de méthodes de transfert de couches limites liquide-gaz.

7. Utilisation d'un dispositif selon au moins l'une des revendications 1 à 5 en tant qu'éclairage de fond pour les afficheurs à cristaux liquides.
